(19) **Europäisches Patentamt / European Patent Office / Office européen des brevets**

(11) **EP 3 185 119 A1**

(12) **EUROPEAN PATENT APPLICATION**

(43) Date of publication:
**28.06.2017 Bulletin 2017/26**

(21) Application number: **16206697.1**

(22) Date of filing: **23.12.2016**

(51) Int Cl.:
*G06F 3/12* (2006.01)    *B41J 3/36* (2006.01)
*B41J 3/407* (2006.01)    *G06F 1/26* (2006.01)
*B41J 29/393* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **25.12.2015 JP 2015253625**

(71) Applicant: **Seiko Epson Corporation
Tokyo 160-8801 (JP)**

(72) Inventor: **MURAYAMA, Noriaki
Nagano, 392-8502 (JP)**

(74) Representative: **MERH-IP Matias Erny Reichl Hoffmann
Patentanwälte PartG mbB
Paul-Heyse-Strasse 29
80336 München (DE)**

(54) **JUDGMENT DEVICE, PROGRAM, JUDGMENT METHOD IN JUDGMENT DEVICE, AND PRINTER**

(57) A judgment device includes a remaining power acquisition section (26a) adapted to obtain a remaining battery power of a battery (132) as a power source of a printer (1), an arithmetic section (26c) adapted to calculate a predicted power consumption of the battery (132) consumed by execution of a print job, and a judgment section adapted to judge whether or not the battery (132) has the remaining battery power, with which the printer (1) can complete the print job, based on the remaining battery power and the predicted power consumption.

FIG.11

**Description**

BACKGROUND

1. Technical Field

The present invention relates to a judgment device, a program, a judgment method in the judgment device, and a printer each for judging whether or not the printer can complete a print job.

2. Related Art

In the past, there has been known a printer which judges, in the case in which the number of print sheets in a print job is equal to or smaller than a predetermined number of sheets, and the remaining power of a battery is equal to or higher than a predetermined threshold value, that the print job can be completed (see JP-A-2014-188931).

The inventors found out the following problem. In the related art printer, it is judged without exception, in the case in which the number of print sheets in a print job is equal to or smaller than a predetermined number of sheets, and the remaining power of a battery is equal to or higher than a predetermined threshold value, that the print job can be completed. Therefore, in the case in which the consumed power of the battery consumed by the print job of a predetermined number of sheets becomes higher than usual in accordance with the print density or the like, there is a possibility that it is faultily judged that the print job can be completed despite the fact that the print job cannot be completed.

SUMMARY

The invention provides a judgment device, a program, a judgment method in the judgment device, and a printer each capable of preventing a printer from faultily judging that the print job can be completed.

A judgment device according to an aspect of the invention includes a remaining power acquisition section adapted to obtain a remaining battery power of a battery as a power source of a printer, an arithmetic section adapted to calculate a predicted power consumption of the battery consumed by execution of a print job (e.g., a consumption of battery power that results from execution of the print job), and a judgment section adapted to judge whether or not the battery has the remaining battery power, with which the printer can complete the print job (e.g., whether the battery has sufficient remaining power to allow completing the print job by the printer), based on the remaining battery power and the predicted power consumption. The printer may comprise or may be coupled to the battery as its power source.

A judgment method in a judgment device according to another aspect of the invention includes the steps of obtaining a remaining battery power of a battery as a power source of a printer, calculating a predicted power consumption of the battery consumed by execution of a print job, and judging whether or not the battery has the remaining battery power, with which the printer can complete the print job, based on the remaining battery power and the predicted power consumption. The printer may comprise or may be coupled to the battery as its power source.

A printer according to another aspect of the invention includes a printing section adapted to perform printing on a print medium and the judgment device described here and elsewhere.

A printer according to another aspect of the invention includes a printing section adapted to perform printing on a print medium, a remaining power acquisition section adapted to obtain a remaining battery power of a battery as a power source, an arithmetic section adapted to calculate a predicted power consumption of the battery consumed by execution of a print job, and a judgment section adapted to judge whether or not the battery has the remaining battery power, with which the print job can be completed, based on the remaining battery power and the predicted power consumption. The printer may comprise or may be coupled to the battery as its power source.

In the above and in the following, the terms "power" and "energy" may be used synonymously, unless expressly indicated otherwise.

According to the configuration described above, based on the predicted power consumption calculated by the arithmetic section, whether or not the battery has the remaining battery power with which the printer can complete the print job is judged by the judgment section. Thus, even in the case in which the predicted power consumption varies in accordance with the content of the print job, it can be appropriately judged whether or not the battery has the remaining battery power with which the printer can complete the print job. Therefore, according to the present configuration, it is possible to prevent the printer from faultily judging that the print job can be completed.

In the judgment device described above, the arithmetic section may calculate the predicted power consumption based on a print density in the print job (e.g., of the print job). The print density may indicate a number of dots per unit length, such as a number of dots per inch (dpi), for example. Alternatively, the print density may relate to one of a plurality of consecutive levels or degrees, each representing a respective print density.

According to this configuration, even in the case in which the predicted power consumption varies in accordance with the print density, the predicted power consumption can appropriately be calculated.

Alternatively or additionally, the arithmetic section may calculate the predicted power consumption based on a number of times of a cutting process adapted to cut a print medium in the print job (e.g., based on a number of times of executing the cutting process during the print job).

According to this configuration, even in the case in which the predicted power consumption varies in accordance with the number of times of the cutting process, the predicted power consumption can appropriately be calculated.

Further, the judgment device may include a threshold value acquisition section adapted to obtain a remaining power threshold value, and the judgment section may make a judgment on whether or not a predicted remaining power as a difference obtained by subtracting the predicted power consumption from the remaining battery power is one of equal to and higher than the remaining power threshold value as the judgment on whether or not the battery has the remaining battery power with which the printer can complete the print job.

According to this configuration, in the case in which the predicted remaining power is equal to or higher than the remaining power threshold value, it is judged that the battery has the remaining battery power with which the printer can complete the print job. Further, in the case in which the predicted remaining power is lower than the remaining power threshold value, it is judged that the battery fails to have the remaining battery power with which the printer can complete the print job.

In this case, the threshold acquisition section may obtain the remaining power threshold value differently between types of the battery. For example, the threshold acquisition section may obtain (e.g., determine) the remaining power threshold value on the basis of (e.g., depending on) a type of the battery.

According to this configuration, as the remaining power threshold value, the value added with (e.g., accounting for) the discharge characteristic of the battery can be obtained.

The remaining power acquisition section may obtain the remaining battery power while performing printing (e.g., while the printer performs printing) on an n-th label (n is an integer no smaller than 1) out of the print job of performing printing on a plurality of labels, the arithmetic section may calculate a value consumed by execution of the print job of performing printing on an (n+1)-th label and following labels (e.g. , the remaining labels among the plurality of labels after the n-th label) as the predicted power consumption, and the judgment section may judge whether or not the battery has the remaining battery power with which the printer can complete the print job of performing printing on the (n+1)-th label and the following labels based on the remaining battery power obtained while performing printing on the n-th label, and the predicted power consumption. For example, if the print job performs printing on a plurality of N labels (N is an integer no smaller than 1), the labels following the (n+1)-th label may indicate the (n+2)-th label up to the N-th label.

According to this configuration, the remaining battery power is obtained in real time while performing printing on the plurality of labels. Therefore, according to the present configuration, whether or not the battery has the remaining battery power with which the printer can complete the print job can be more appropriately judged.

The judgment device may further include an annunciation section adapted to give (e. g. , generate) a message in a case in which the judgment section judges that the battery fails to have the remaining battery power with which the printer can complete the print job.

According to this configuration, it is possible to notify the user of the fact that the battery fails to have the remaining battery power with which the printer can complete the print job.

A program according to another aspect of the invention is for making an information processing device (e.g. , when the program is executed by the information processing device) function as the judgment device described above.

A program according to yet another aspect of the invention is for making an information processing device (e.g. , when the program is executed by the information processing device) perform the method steps of the method described above .

BRIEF DESCRIPTION OF THE DRAWINGS

The invention will be described with reference to the accompanying drawings, wherein like numbers reference like elements.

Fig. 1 is an external view of an example of a print system provided with an information processing device according to an embodiment of the invention.
Fig. 2 is a diagram showing an example of a character input screen.
Fig. 3 is a diagram showing an example of a configuration screen.
Fig. 4 is a block diagram of an example of a print system.
Fig. 5 is a diagram for explaining an example of a remaining power threshold value table.
Fig. 6 is a diagram for explaining an example of a power consumption table.
Fig. 7 is a diagram for explaining an example of a print density factor table.
Fig. 8 is a diagram for explaining an example of a print color density factor table.

Fig. 9 is a diagram for explaining an example of a print speed factor table.

Fig. 10 is a diagram for explaining an example of an environmental temperature factor table.

Fig. 11 is a diagram showing an example of a functional configuration of a processing-side control circuit.

Fig. 12 is a flowchart showing an example of a processing sequence of the processing-side control circuit after starting up corresponding software.

Fig. 13 is a flowchart following the flowchart shown in Fig. 12.

Fig. 14 is a flowchart showing an example of a remaining battery power judgment process.

## DESCRIPTION OF AN EXEMPLARY EMBODIMENT

Hereinafter, an example embodiment of the invention will be described with reference to the accompanying drawings.

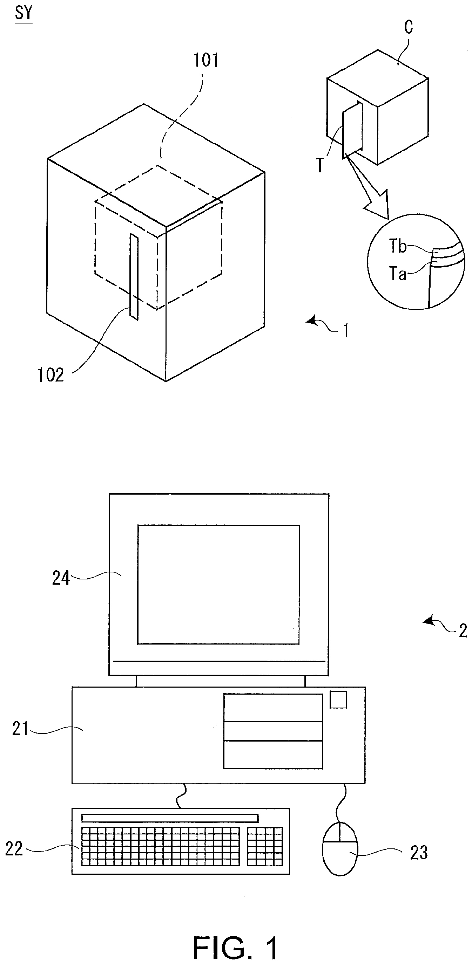

Based on the example of Fig. 1, a print system SY provided with an information processing device 2 according to the embodiment of the invention will be described. The print system SY is provided with a tape printer 1 (as an example of a printer) and an information processing device 2. The tape printer 1 and the information processing device 2 are connected to each other wirelessly or with wire so as to be able to communicate with each other.

The tape printer 1 is, for example, provided with a cartridge mount 101 and a tape discharge port 102. The tape printer 1 performs printing and cutting on a tape T in a tape cartridge C mounted on the cartridge mount 101 based on the print data received from the information processing device 2. The tape T is provided with a tape main body Ta on which a print image is printed, and release paper Tb detachably attached to an adhesive surface of the tape main body Ta. Among the parts of the tape T discharged from the tape discharge port 102, the tape main body Ta peeled from the release paper Tb can be attached to a desired place.

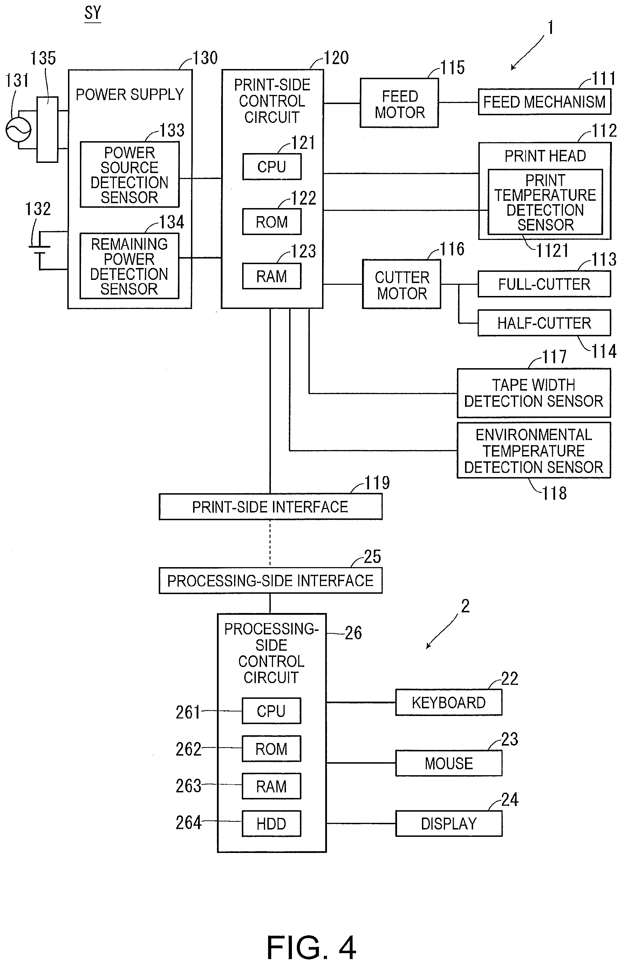

As the tape cartridge C, there is prepared a plurality of types different in tape width of the tape T housed in the tape cartridge. Therefore, the cartridge mount 101 is provided with a tape width detection sensor 117 (see Fig. 4) .

Further, although not shown in the drawings, the tape printer 1 is provided with an adapter insertion port and a battery mount. To the adapter insertion port, there is inserted an AC adapter 135 (see Fig. 4). To the battery mount, there is attached one or more batteries (e. g. , a plurality of batteries) 132 (see Fig. 4) in series to each other.

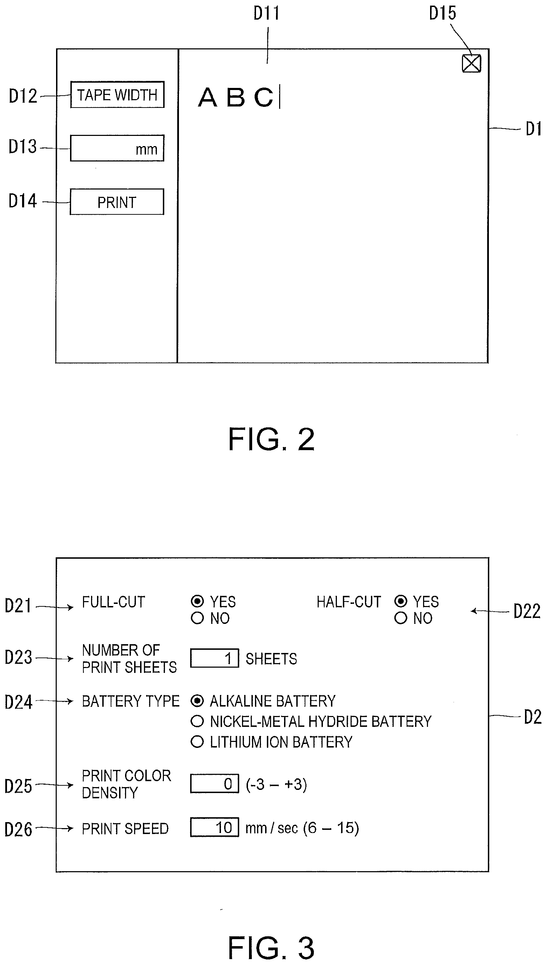

The information processing device 2 is, for example, a general-purpose personal computer, and application software (hereinafter referred to as "corresponding software") corresponding to the tape printer 1 is installed in the information processing device 2. The information processing device 2 is provided with a PC main body 21, a keyboard 22, a mouse 23, and a display 24. The PC main body 21 incorporates a processing-side control circuit 26 (see Fig. 4) described later. The keyboard 22 and the mouse 23 accept a variety of types of input operations such as input of a character. It should be noted that the character is a concept including a letter, a symbol, a pictogram, and so on. The display 24 may display a character input screen D1 (see Fig. 2), a configuration screen D2 (see Fig. 3), and so on described later. The information processing device 2 generates print data, for example based on the input operations accepted by the keyboard 22 and the mouse 23, and then transmits the print data thus generated to the tape printer 1.

An example of the character input screen D1 will be described based on Fig. 2. On the character input screen D1, there are displayed a character input field D11, a tap width acquisition button D12, a tape width display field D13, a print button D14, and an end button D15. In the character input field D11, there are displayed the characters input from the keyboard 22. The tape width acquisition button D12 accepts an operation of the information processing device 2 for obtaining a tape width detected by the tape width detection sensor 117 from the tape printer 1. In the tape width display field D13, there is displayed the tape width obtained by pressing the tape width acquisition button D12. Thus, it is possible to make a user to check the tape width of the tape T housed in the tape cartridge C attacked to the tape printer 1. The print button D14 accepts an operation of making the tape printer 1 perform a print process. The end button D15 accepts an operation for ending the corresponding software.

An example of the configuration screen D2 will be described based on Fig. 3. On the configuration screen D2, there are displayed a full-cut setting field D21, a half-cut setting field D22, a number of print sheets setting field D23, a battery type setting field D24, a print color density setting field D25, and a print speed setting field D26. It should be noted that, naturally, these fields can also be separately displayed in a plurality of screens.

In the full-cut setting field 21, whether or not full-cut is performed in the tape printer 1 is selectively displayed. The full-cut denotes cutting both of the tape main body Ta and the release paper Tb in the width direction of the tape T using a full-cutter 113 (see Fig. 4). It should-be noted that, for example, the full-cut is set to "ON" by default.

In the half-cut setting field D22, whether or not half-cut is performed in the tape printer 1 is selectively displayed. The half-cut denotes cutting the tape main body Ta without cutting the release paper Tb using a half-cutter 114 (see Fig. 4). It should be noted that, for example, the half-cut is set to "ON" by default.

To the number of print sheets setting field D23, there can be input the number N of print sheets (e.g., labels). In the case in which "3" sheets, for example, is input in the number of print sheets setting field D23, the tape printer 1 performs printing on three labels continuously. It should be noted that the number N of print sheets is set to, for example, "1" by default.

In the battery type setting field D24, there can be selectively displayed a plurality of types of battery (e.g., three types, namely alkaline battery, nickel-metal hydride battery, and lithium ion battery). In the case in which the AC adapter 135 is not connected to the adapter insertion port of the tape printer 1, the user can select the type of the battery 132 attached to the battery mount from among the alternatives displayed in the battery type setting field D24. It should be noted that the battery type is set to, for example, "alkaline battery" by default.

In the print color density setting field D25, there can be input the print color density selected from among a plurality of levels (e.g., 7 levels from -3 to +3). The print color density is set to, for example, "0" by default. To the print color density setting field D25, the user can input higher print color density in the case in which the previous print result by the tape printer 1 is pale (e. g. , too pale), and input lower print color density in the case in which the previous print result is dark (e.g., too dark). The tape printer 1 may change a period of energization to a heating element provided to a print head 112 (see Fig. 4) in accordance with the print color density thus set. It should be noted that the print color density may also be automatically adjusted during printing in accordance with the print temperature measured by a print temperature detection sensor 1121 (see Fig. 4).

In the print speed setting field D26, there can be input the print speed selected from among a plurality of levels (e.g., 10 levels from 6 mm/sec to 15 mm/sec, in increments of 1 mm/sec). The print speed is set to, for example, "10" mm/sec by default. In the case in which, for example, a faint print occurs in the print result, the user can input a lower print speed to the print speed setting field D26. The tape printer 1 changes the print speed, namely feed speed of the tape T, in accordance with the print speed thus set. It should be noted that in the case in which "alkaline battery" or "nickel-metal hydride battery" is set in the battery type setting field D24, the lowest print speed may be set irrespective of the selection result of the print speed setting field D26. This is because, since the alkaline battery and the nickel-metal hydride battery vary in voltage with relative ease, in the case in which the alkaline battery or the nickel-metal hydride battery is used as the power source, it is difficult for the tape printer 1 to perform printing at high speed.

The tape printer 1 and the information processing device 2 will be described based on the example of Fig. 4. In this example, the tape printer 1 is provided with a feed mechanism 111, the print head 112, the full-cutter 113, the half-cutter 114, a feed motor 115, a cutter motor 116, the tape width detection sensor 117, an environmental temperature detection sensor 118, a print-side interface 119, a print-side control circuit 120, and a power supply 130.

The feed mechanism 111 rotates a platen roller (not shown) housed in the tape cartridge C in the state in which the tape cartridge C is mounted on the cartridge mount 101. Thus, the tape T and an ink ribbon (not shown) housed in the tape cartridge C are fed.

The print head 112 is provided with a plurality of (e.g., 384 pieces of) heating elements arranged in a direction perpendicular to the feed direction of the tape T. Each of the heating elements generates heat based on the print data received in the state in which the tape T and the ink ribbon are held between the heating element and the platen roller. Thus, the ink in the ink ribbon is transferred to the tape T, and thus the characters (e.g., indicated by the print data) are printed on the tape T. Further, the print head 112 incorporates the print temperature detection sensor 1121. The print temperature detection sensor 1121 measures the print temperature, namely the heating temperature of the heating elements.

The full-cutter 113 performs the full-cut on the tape T at a position behind the part of the tape T on which printing has been performed. Thus, the part of the tape T on which printing has been performed is separated. The half-cutter 114 performs the half-cut on the tape T at, for example, a position between a tip and a print start position of the tape T. Thus, a cut is made in the tape T, and it becomes easy to peel the tape main body Ta from the release paper Tb. It should be noted that in the case of performing printing on a plurality of labels continuously, if the full-cut is set to "YES" in the full-cut setting field D21, and the half-cut is set to "YES" in the half-cut setting field D22, the full-cut and the half-cut at a position between a tip and a print start position are performed in every label. Further, if the full-cut is set to "NO" in the full-cut setting field D21, and the half-cut is set to "YES" in the half-cut setting field D22, the half-cut is performed at the position between the second label and the following labels besides the position between the tip of the tape T and the print start position of the first label.

The feed motor 115 acts as a drive source of the feed mechanism 111. The cutter motor 116 acts as a drive source of the full-cutter 113 and the half-cutter 114.

The tape width detection sensor 117 detects the type of the tape cartridge C mounted on the tape printer 1, namely the tape width of the tape T housed in the tape cartridge C. The environmental temperature detection sensor 118 detects the environmental temperature of the tape printer 1.

The print-side interface 119 transmits and receives a variety of commands and a variety of types of data with a processing-side interface 25 described later.

The print-side control circuit 120 controls each part of the tape printer 1. An example of the print-side control circuit 120 is provided with a central processing unit (CPU) 121, a read-only memory (ROM) 122, and a random access memory (RAM) 123. The CPU 121 executes a variety of programs stored in the ROM 122 using the RAM 123 to thereby perform a variety of processes.

The power supply 130 supplies the each part of the tape printer 1 with electrical power using a commercial power source 131 or the battery 132 as the power source. An example of the power supply 130 is provided with a power source detection sensor 133. The power source detection sensor 133 detects presence or absence of the connection of the AC adapter 135 to the adapter insertion port. In the case in which the power source detection sensor 133 has detected the connection of the AC adapter 135, the power supply 130 supplies the electrical power using the commercial power source 131 as the power source irrespective of whether or not the battery 132 is mounted. In contrast, in the case in which the power source detection sensor 133 has detected that the AC adapter 135 is not connected, the power supply 130 supplies the electrical power using the battery 132 as the power source.

Further, the power supply 130 is provided with a remaining power detection sensor 134. The remaining power detection sensor 134 detects the remaining power (hereinafter referred to as "remaining battery power $W_R$") of the battery 132. The remaining power detection sensor 134 measures, for example, the voltage of the battery 132 as the remaining battery power $W_R$ (e. g. , as an indication of the remaining battery power $M_R$).

The information processing device 2 is provided with the keyboard 22, the mouse 23, the display 24, the processing-side interface 25, and the processing-side control circuit 26.

The processing-side interface 25 transmits and receives a variety of commands and a variety of types of data with the print-side interface 119 described above.

The processing-side control circuit 26 is provided with a CPU 261, a ROM 262, a RAM 263, and a hard disk drive (HDD) 264. The CPU 261 executes a variety of programs stored in the ROM 262 and the HDD 264 using the RAM 263 to thereby perform a variety of processes.

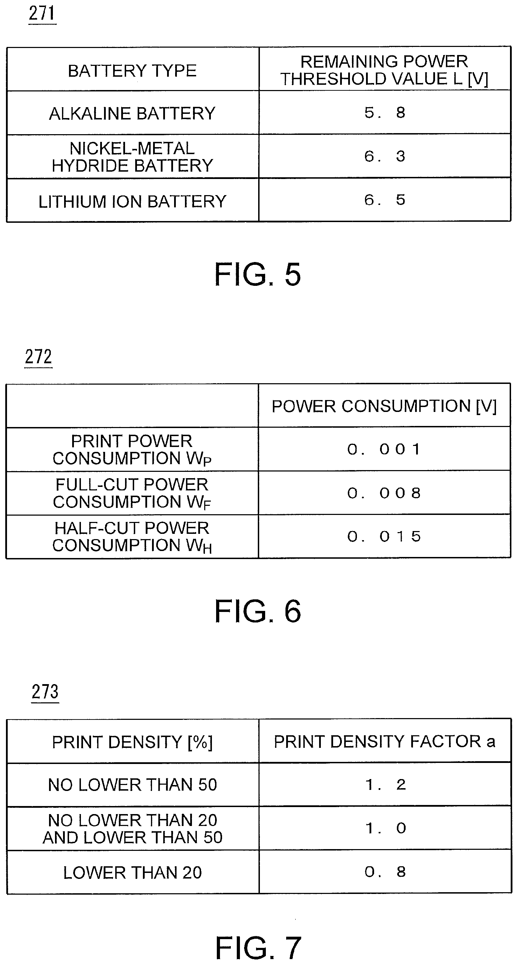

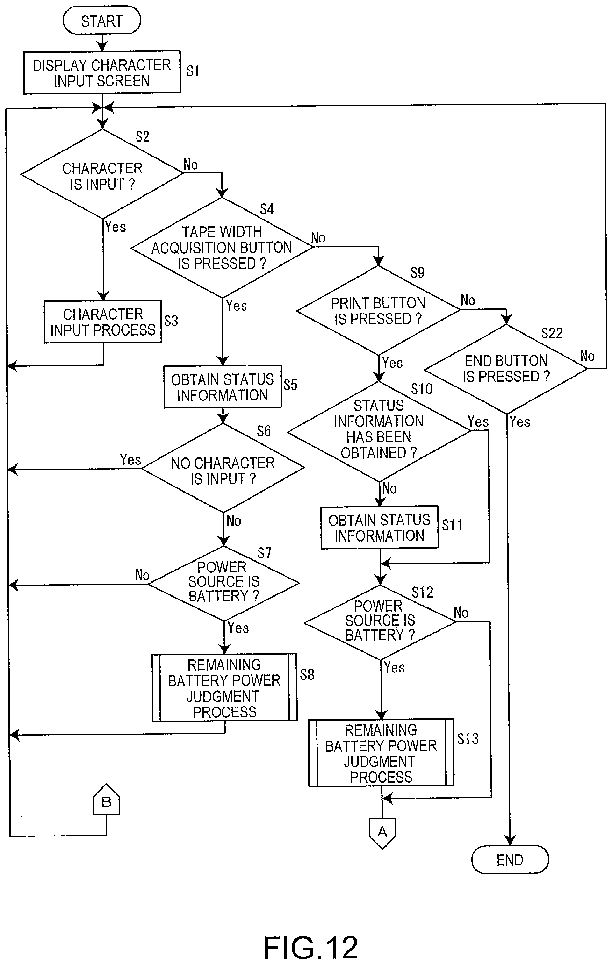

The HDD 264 stores the corresponding software. The corresponding software includes a remaining battery power judgment processing program (see Fig. 12 through Fig. 14). Further, as shown in Fig. 5 through Fig. 10, the corresponding software includes a remaining power threshold value table 271, a power consumption table 272, a print density factor table 273, a print color density factor table 274, a print speed factor table 275, and an environmental temperature factor table 276. These programs and tables are used mainly in a remaining battery power judgment process described later. It should be noted that, naturally, the numerical values shown in the respective tables in the examples of Fig. 5 through Fig. 10 are illustrative only, but the invention is not limited to these values.

An example of the remaining power threshold value table 271 will be described based on Fig. 5. The remaining power threshold value table 271 has the types (hereinafter referred to as "battery types") of the battery 132 and the remaining power threshold values L so as to be associated with each other. The remaining power threshold value L is a threshold value used by the processing-side control circuit 26 when judging whether the battery 132 has the remaining battery power $W_R$ with which the tape printer 1 can complete a print job in the remaining battery power judgment process. The remaining power threshold value L of the alkaline battery is set to a lower value compared to the remaining power threshold value L of the nickel-metal hydride battery and the remaining power threshold value L of the lithium ion battery. This is due to the difference in discharge characteristic between the batteries. Specifically, this is because, the alkaline battery rapidly decreases in voltage when the discharge progresses compared to the nickel-metal hydride battery and the lithium ion battery.

An example of the power consumption table 272 will be described based on Fig. 6. In the power consumption table 272, there are set the values of print power consumption $W_P$, full-cut power consumption $W_F$, and half-cut power consumption $W_H$. The print power consumption $W_P$ denotes the power consumption of the battery 132 per unit length (e.g., 1 cm) of the tape T when the tape printer 1 has performed printing on the tape T. The full-cut power consumption $W_F$ denotes the power consumption of the battery 132 corresponding to the full-cut performed once. The half-cut power consumption $W_H$ denotes the power consumption of the battery 132 corresponding to the half-cut performed once.

An example of the print density factor table 273 will be described based on Fig. 7. The print density factor table 273 has the print densities and the print density factors a so as to be associated with each other. The print density denotes the proportion of the number of dots corresponding to the heating elements to be heated out of the total number of dots in the print data (dot-pattern data). The higher the print density is, the larger the number of heating elements to be heated becomes, and the higher the power consumption of the battery 132 becomes. Therefore, in the print density factor table 273, the print density factor a is set to be large so that the higher the print density becomes, the higher the predicted power consumption $W_C$ described later is calculated.

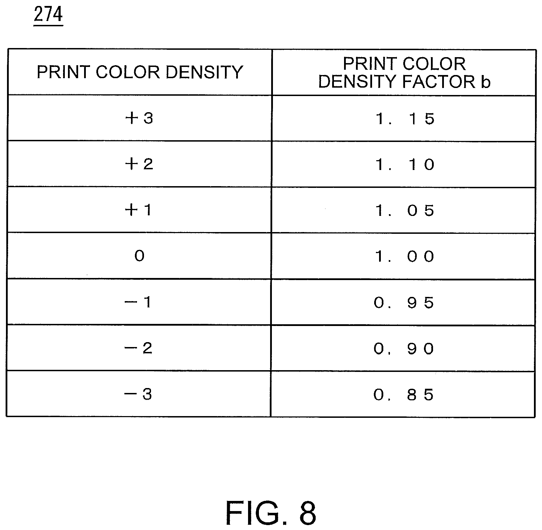

An example of the print color density factor table 274 will be described based on Fig. 8. The print color density factor table 274 has the print color densities and the print color density factors b so as to be associated with each other. The higher the print color density becomes, the longer the energization period to the heating elements provided to the print head 112 becomes, and the higher the power consumption of the battery 132 becomes. Therefore, in the print color density factor table 274, the print color density factor b is set to be large so that the higher the print color density becomes, the higher the predicted power consumption $W_C$ is calculated.

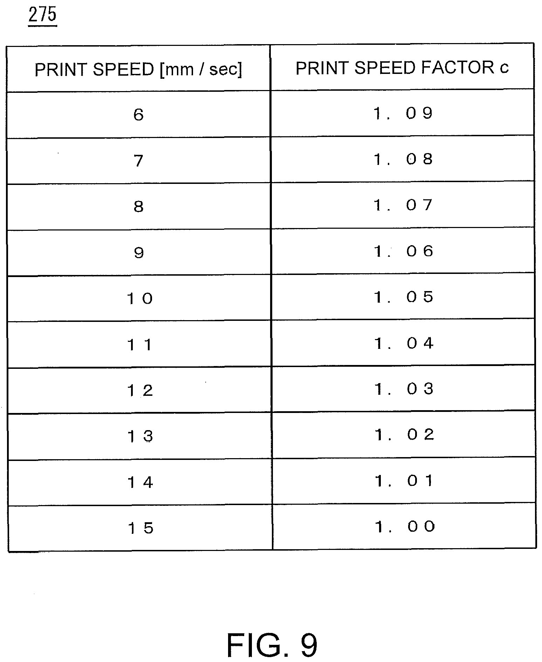

An example of the print speed factor table 275 will be described based on Fig. 9. The print speed factor table 275 has the print speed values and the print speed factors c so as to be associated with each other. The higher the print speed becomes, the higher the heat efficiency becomes to make it sufficient for the energization period to the heating elements to be shorter, and the lower the power consumption of the battery 132 becomes. Therefore, in the print speed factor table 275, the print speed factor c is set to be small so that the higher the print speed becomes, the lower the predicted power consumption $W_C$ is calculated.

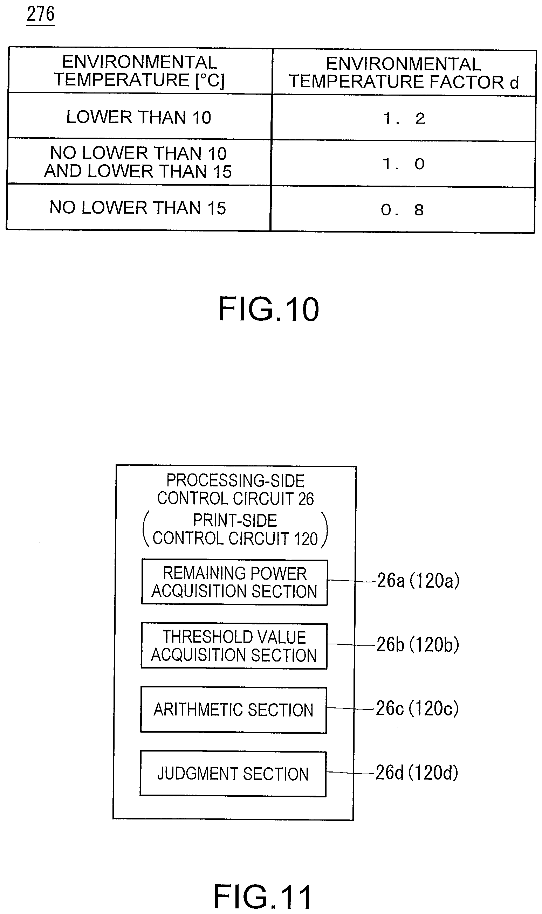

An example of the environmental temperature factor table 276 will be described based on Fig. 10. The environmental temperature factor table 276 has the environmental temperature values and the environmental temperature factors d so as to be associated with each other. The higher the environmental temperature becomes, the shorter it is sufficient for the energization period to be, and the lower the power consumption of the battery 132 becomes. Therefore, in the environmental temperature factor table 276, the environmental temperature factor d is set to be small so that the higher the environmental temperature becomes, the lower the predicted power consumption $W_C$ is calculated.

An example of a functional configuration of the processing-side control circuit 26 will be described based on Fig. 11. The processing-side control circuit 26 is provided with a remaining power acquisition section 26a, a threshold value acquisition section 26b, an arithmetic section 26c, and a judgment section 26d. These functional sections may be each realized by cooperation of the hardware constituting the processing-side control circuit 26 and the software such as the remaining battery power judgment processing program.

The remaining power acquisition section 26a obtains the remaining battery power $W_R$, for example based on the output from the remaining power detection sensor 134 of the tape printer 1.

The threshold value acquisition section 26b obtains the remaining power threshold value L, for example by looking up the remaining power threshold value table 271 to obtain the remaining power threshold value L associated with the battery type set in the battery type setting field D24.

The arithmetic section 26c calculates the predicted power consumption $W_C$ of the battery 132 to be consumed by the execution of the print job, for example based on the following formula.

$$W_C = \{ (a \times b \times c \times d \times W_P \times D) + (W_F \times M_F) + (W_H \times M_H) \} \times N$$

$W_C$: predicted power consumption [V]
a: print density factor
b: print color density factor
c: print speed factor
d: environmental temperature factor
$W_P$: print power consumption [V/cm]
D: print length [cm]
$W_F$: full-cut power consumption [V/times]
$M_F$: Number of times of full-cut [times]
$W_H$: half-cut power consumption [V/times]
$M_H$: Number of times of half-cut [times]
N: number of labels printed in a print job

Depending on specific use cases, any of the additive terms inside the curly bracket in the above formula may be omitted. For instance, if no cutting is to be performed, only the first additive term may be retained (i.e., $M_F$ and/or $M_H$ may be set to zero, as described further below). Moreover, any of the multiplicative factors a, b, c, and d may be omitted (i.e., may be set to 1).

As the print density factor a, the arithmetic section 26c uses a value associated with the print density of the print data generated in the print density factor table 273. As the print color density factor b, the arithmetic section 26c uses a value associated with the print color density adjusted in accordance with the print color density set in the print color density setting field D25 or the print temperature detected by the print temperature detection sensor 1121 in the print color density factor table 274. As the print speed factor c, the arithmetic section 26c uses a value associated with the print speed set in the print speed setting field D26 in the print speed factor table 275. As the environmental temperature factor d, the arithmetic section 26c uses a value associated with the environmental temperature detected by the environmental temperature detection sensor 118 in the environmental temperature factor table 276.

As the print power consumption $W_P$, the arithmetic section 26c uses the value set in the power consumption table 272. As the print length D (the length of the tape T fed), the arithmetic section 26c uses the value calculated based on the characters and so on input (e.g., input with the print data).

As the full-cut power consumption $W_F$, the arithmetic section 26c uses the value set in the power consumption table 272. As the number $M_F$ of times of full-cut, the arithmetic section 26c uses "1" in the case in which "YES" is selected in the full-cut setting field D21, or uses "0" in the case in which "NO" is selected in the full-cut setting field D21.

As the half-cut power consumption $W_H$, the arithmetic section 26c uses the value set in the power consumption table 272. As the number $M_H$ of times of half-cut, the arithmetic section 26c uses "1" in the case in which "YES" is selected in the half-cut setting field D22, or uses "0" in the case in which "NO" is selected in the half-cut setting field D22.

As the number N of print sheets (e.g., labels), the arithmetic section 26c uses the value input in the number of print sheets setting field D23.

The judgment section 26d judges whether or not the battery 132 has the remaining battery power $W_R$ with which the tape printer 1 can complete the print job based on the remaining battery power $W_R$ detected by the remaining power detection sensor 134 and the predicted power consumption $W_C$ calculated by the arithmetic section 26c. Specifically, the judgment section 26d judges whether or not the difference (hereinafter referred to as a "predicted remaining power $W_D$") obtained by subtracting the predicted power consumption $W_C$ from the remaining battery power $W_R$ is equal to or higher than the remaining power threshold value L obtained by the threshold value acquisition section 26b.

Based on Fig. 12 through Fig. 14, an example of the processing sequence of the processing-side control circuit 26 after starting up the corresponding software will be described. After the corresponding software has been started up, the processing-side control circuit 26 makes the display 24 display the character input screen D1 in step S1.

In step S2, the processing-side control circuit 26 judges whether or not a character has been input from the keyboard 22. In the case in which the processing-side control circuit 26 has judged that the character has been input from the keyboard 22 (Yes in the step S2), the process proceeds to the step S3. In contrast, in the case in which the processing-side control circuit 26 has judged that the character has not been input from the keyboard 22 (No in the step S2), the process proceeds to the step S4.

In step S3, the processing-side control circuit 26 performs a character input process. Specifically, the processing-side control circuit 26 stores code data corresponding to the character input from the keyboard 22 in the RAM 263. Further, the processing-side control circuit 26 makes the character thus input be displayed in the character input field D11 based on the code data thus stored. When the processing-side control circuit 26 performs the character input process, the process returns to the step S2.

In step S4, the processing-side control circuit 26 judges whether or not the tape width acquisition button D12 has been pressed. In the case in which the processing-side control circuit 26 has judged that the tape width acquisition button D12 has been pressed (Yes in the step S4), the process proceeds to the step S5. In contrast, in the case in which the processing-side control circuit 26 has judged that the tape width acquisition button D12 has not been pressed (No in the step S4), the process proceeds to the step S9.

In step S5, the processing-side control circuit 26 transmits a status information request to the tape printer 1, and then obtains the status information transmitted from the tape printer 1 in response to the status information request. The status information for example includes the environmental temperature, the print temperature, the type of the power source, the remaining battery power $W_R$, and so on detected by the respective sensors besides the tape width detected by the tape width detection sensor 117. It should be noted that on this occasion, since the tape printer 1 is in a no-load state, the remaining battery power $W_R$, for example the voltage value, detected by the remaining power detection sensor 134 becomes higher than the voltage value detected by the remaining power detection sensor 134 during the print process as a loaded state in some cases. Therefore, it is also possible to, for example, apply a voltage to the print head 112 to the extent that printing is not performed on the tape T, so that the voltage is accurately detected by the remaining power detection sensor 134. The same also applies to the period of obtaining the status information in step S11 described later.

In step S6, the processing-side control circuit 26 judges whether or not no character has been input based on the presence or absence of the code data stored in the RAM 263. In the case in which the processing-side control circuit 26 has judged that some character has been input (No in step S6), the process proceeds to step S7. In contrast, in the case in which the processing-side control circuit 26 has judged that no character has been input (Yes in step S6), the process returns to step S2.

In step S7, the processing-side control circuit 26 judges whether or not the type of the power source is the battery 132, for example based on the type of the power source included in the status information. In the case in which the processing-side control circuit 26 has judged that the type of the power source is the battery 132 (Yes in step S7), the process proceeds to step S8. In contrast, in the case in which the processing-side control circuit 26 has judged that the type of the power source is not the battery 132 (No in step S7), the process returns to step S2.

In step S8, the processing-side control circuit 26 performs the remaining battery power judgment process. After the processing-side control circuit 26 has performed the remaining battery power judgment process, the process returns to step S2.

In step S9, the processing-side control circuit 26 judges whether or not the print button D14 has been pressed. In the case in which the processing-side control circuit 26 has judged that the print button D14 has been pressed (Yes in step S9), the process proceeds to step S10. In the case in which the processing-side control circuit 26 has judged that the print button D14 has not been pressed (No in step S9), the process proceeds to step S22.

In step S10, the processing-side control circuit 26 judges whether or not the status information has been obtained. In the case in which the processing-side control circuit 26 has judged that the status information has not been obtained (No in step S10), the process proceeds to step S11. In contrast, in the case in which the processing-side control circuit 26 has judged that the status information has already been obtained (Yes in step S10), the process proceeds to step S12.

In step S11, the processing-side control circuit 26 transmits the status information request to the tape printer 1, and then obtains the status information transmitted from the tape printer 1 in response to the status information request.

In step S12, the processing-side control circuit 26 judges whether or not the type of the power source is the battery 132, for example based on the type of the power source included in the status information. In the case in which the processing-side control circuit 26 has judged that the type of the power source is the battery 132 (Yes in step S12), the process proceeds to step S13. In contrast, in the case in which the processing-side control circuit 26 has judged that the type of the power source is not the battery 132 (No in step S12), the process proceeds to step S14.

In step S13, the processing-side control circuit 26 performs the remaining battery power judgment process. After the processing-side control circuit 26 has performed the remaining battery power judgment process, the process proceeds to step S14.

In step S14, the processing-side control circuit 26 transmits the print data to the tape printer 1, and at the same time, instructs the tape printer 1 to start the print job. The tape printer 1 performs the print process (e.g., print job) based on the print data received.

In step S15, the processing-side control circuit 26 initializes a variable n to "1."

In step S16, the processing-side control circuit 26 transmits the status information request to the tape printer 1 which is performing the print process, and then obtains the status information transmitted from the tape printer 1 in response to the status information request. The processing-side control circuit 26 updates the status information having already been obtained to the status information obtained most recently.

In step S17, the processing-side control circuit 26 judges whether or not a print completion notification of the n-th label has been received from the tape printer 1. In the case in which the processing-side control circuit 26 has judged that the print completion notification of the n-th label has been received (Yes in step S17), the process proceeds to step S18. In contrast, in the case in which the processing-side control circuit 26 has judged that the print completion notification of the n-th label has not been received (No in step S17), the process returns to step S16.

In step S18, the processing-side control circuit 26 judges whether or not the type of the power source is the battery 132, for example based on the type of the power source included in the status information. In the case in which the processing-side control circuit 26 has judged that the type of the power source is the battery 132 (Yes in step S18), the process proceeds to step S19. In contrast, in the case in which the processing-side control circuit 26 has judged that the type of the power source is not the battery 132 (No in step S18), the process proceeds to step S20.

In step S19, the processing-side control circuit 26 performs the remaining battery power judgment process. After the processing-side control circuit 26 performs the remaining battery power judgment process, the process proceeds to step S20.

In step S20, the processing-side control circuit 26 judges whether or not the print job has been completed, namely whether or not the variable n is equal to the number N of print sheets. In the case in which the processing-side control circuit 26 has judged that the variable n is equal to the number N of print sheets (Yes in step S20), the process returns to step S2. In contrast, in the case in which the processing-side control circuit 26 has judged that the variable n is not equal to the number N of print sheets (No in step S20), the process proceeds to step S21.

In step S21, the processing-side control circuit 26 adds "1" to the variable n, and the process returns to step S16.

In step S22, the processing-side control circuit 26 judges whether or not the end button D15 has been pressed. In the case in which the processing-side control circuit 26 has judged that the end button D15 has been pressed (Yes in step S22), the process terminates the series of processes to close the corresponding software. In contrast, in the case in which the processing-side control circuit 26 has judged that the end button D15 has not been pressed (No in step S22), the process returns to step S2.

As described above, after the tape width acquisition button D12 is pressed, the processing-side control circuit 26 performs the remaining battery power judgment process (step S8). Further, after the print button D14 is pressed, and before the print process is performed, the processing-side control circuit 26 performs the remaining battery power judgment process (step S13). Further, during the execution of the print process, the processing-side control circuit 26 performs the remaining battery power judgment process (step S19) every time one label is printed.

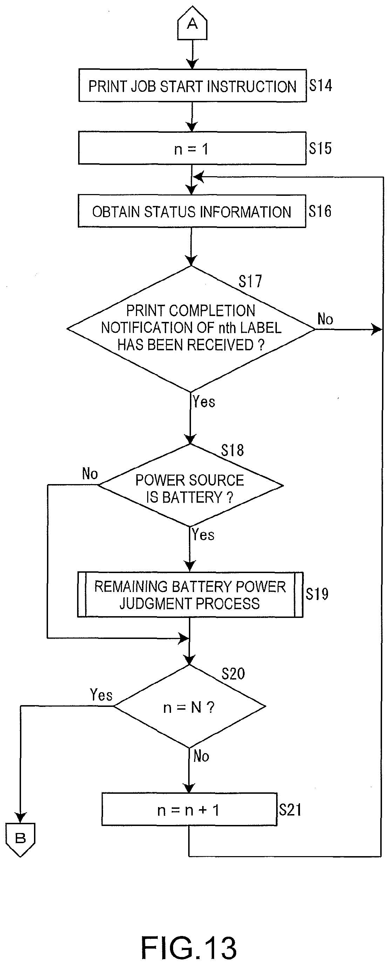

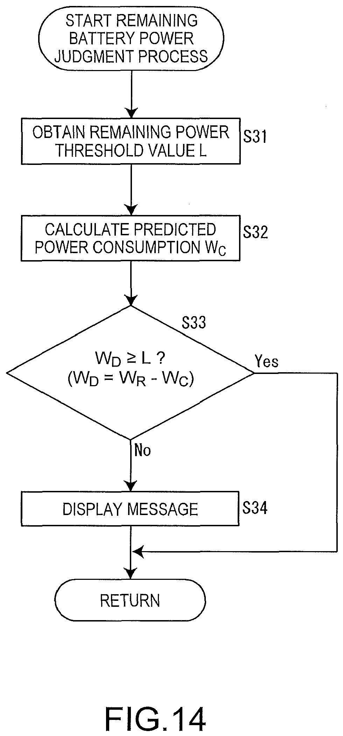

An example of the remaining battery power judgment process performed in step S8, step S13, and step S19 in the flowchart shown in Fig. 12 and Fig. 13 will be described with reference to Fig. 14.

In step S31, the remaining power acquisition section 26a of the processing-side control circuit 26 obtains the remaining power threshold value L.

In step S32, the arithmetic section 26c of the processing-side control circuit 26 calculates the predicted power consumption $W_C$. Here, in the case of the remaining battery power judgment process performed in step S19, the arithmetic section 26c uses (N-n) (N represents the number of print sheets, n represents the variable n) instead of N in the above formula for calculating the predicted power consumption $W_C$. In other words, as the predicted power consumption $W_C$,

the arithmetic section 26c calculates the value consumed by the execution of the print job for performing printing on the (n+1)-th label and the following labels which has not yet been printed. Further, even in the case in which the power consumption of the battery 132 varies due to the adjustment of the print color density during the print process, in the remaining battery power judgment process to be performed in step S19, the predicted power consumption $W_C$ is calculated based on the print color density factor b associated with the print color density thus updated. Therefore, the predicted power consumption $W_C$ is appropriately calculated.

In step S33, the judgment section 26d of the processing-side control circuit 26 judges whether or not the predicted remaining power $W_D$ is equal to or higher than the remaining power threshold value L. Here, as described above, the predicted remaining power $W_D$ is a difference obtained by subtracting the predicted power consumption $W_C$ from the remaining battery power $W_R$. In the remaining battery power judgment process in step S8, as the remaining battery power $W_R$, there is used what is included in the status information obtained in step S5. Further, in the remaining battery power judgment process in step S13, as the remaining battery power $W_R$, there is used what is included in the status information obtained in step S5 or step S11. In contrast, in the remaining battery power judgment process in step S19, there is used what is included in the status information obtained in step S16 (the status information obtained in the most recent step S16 in the case in which step S16 is repeated). Therefore, the remaining battery power $W_R$ varying in the print process can be obtained in real time.

In the case in which the judgment section 26d has judged that the predicted remaining power $W_D$ is lower than the remaining power threshold value L (No in step S33), the process proceeds to step S34. In contrast, in the case in which the judgment section 26d has judged that the predicted remaining power $W_D$ is equal to or higher than the remaining power threshold value L (Yes in step S33), the process returns to the flowchart shown in Fig. 12 and the Fig. 13.

The processing-side control circuit 26 makes the display 24 display the message in step S34, and then the process returns to the flowchart shown in Fig. 12 and Fig. 13. The content of the message is, for example, "BATTERY VOLTAGE IS LOW. PLEASE REPLACE THE BATTERY."

As described above, according to the information processing device 2 related to the present embodiment, there are provided the remaining power acquisition section 26a, the arithmetic section 26c, and the judgment section 26d. The information processing device 2 is an example of a judgment device for judging whether or not the printer can complete a print job. The remaining power acquisition section 26a obtains the remaining battery power $W_R$ of the battery 132 as the power source of the tape printer 1. The arithmetic section 26c calculates the predicted power consumption $W_C$ of the battery 132 to be consumed by the execution of the print job. The judgment section 26d judges whether or not the battery 132 has the remaining battery power $W_R$ with which the tape printer 1 can complete the print job based on the remaining battery power $W_R$ and the predicted power consumption $W_C$.

According to this configuration, based on the predicted power consumption $W_C$ calculated by the arithmetic section 26c, whether or not the battery 132 has the remaining battery power $W_R$ with which the tape printer 1 can complete the print job is judged by the judgment section 26d. Thus, even in the case in which the predicted power consumption $W_C$ varies in accordance with the content of the print job, whether or not the battery 132 has the remaining battery power $W_R$ with which the tape printer 1 can complete the print job can appropriately be judged. Therefore, according to the present configuration, it is possible to prevent the tape printer 1 from faultily judging that the print job can be completed despite that tape printer 1 cannot complete the print job due to the shortage of the remaining battery power $W_R$. Therefore, it is possible to prevent the case in which the remaining battery power $W_R$ becomes short (e.g., insufficient) in the middle of the print process due to the increase in power consumption of the battery 132 as in the case of performing printing on a plurality of labels continuously, and thus printing stops in the middle of the print process. In particular, in the case of serial number printing, if printing stops in the middle of the print process, in the case of a model which cannot automatically resume printing in the middle of the print process, it is required for the user to check the last number printed completely, and then perform setting so that printing resumes from the label with the next number to the last number. The present configuration is particularly advantageous in the point that it is possible to prevent such a trouble from occurring.

Further, according to the information processing device 2 related to the present embodiment, the arithmetic section 26c calculates the predicted power consumption $W_C$ based on the print density used in the print job.

According to this configuration, even in the case in which the predicted power consumption $W_C$ varies in accordance with the print density, the predicted power consumption $W_C$ can appropriately be calculated.

Further, according to the information processing device 2 related to the present embodiment, the arithmetic section 26c calculates the predicted power consumption $W_C$ based on the number of times of the cutting process for cutting the tape T in the print job, for example the number of times of the full-cut and the number of times of the half-cut.

According to this configuration, even in the case in which the predicted power consumption $W_C$ varies in accordance with the number of times of the cutting process, the predicted power consumption $W_C$ can appropriately be calculated.

Further, according to the information processing device 2 related to the present embodiment, there is further provided the threshold value acquisition section 26b for obtaining the remaining power threshold value L. Further, as the judgment on whether or not the battery 132 has the remaining battery power $W_R$ with which the tape printer 1 can complete the print job, the judgment section 26d makes the judgment on whether or not the predicted remaining power $W_D$ as the difference obtained by subtracting the predicted power consumption $W_C$ from the remaining battery power $W_R$ is equal to or higher than the remaining power threshold value L.

According to this configuration, in the case in which the predicted remaining power $W_D$ is equal to or higher than the remaining power threshold value L, it is judged that the battery 132 has the remaining battery power $W_R$ with which the tape printer 1 can complete the print job. Further, in the case in which the predicted remaining power $W_D$ is lower than the remaining power threshold value L, it is judged that the battery 132 fails to have the remaining battery power $W_R$ with which the tape printer 1 can complete the print job.

Further, according to the information processing device 2 related to the present embodiment, the threshold value acquisition section 26b obtains the remaining power threshold value L to be different between the types of the battery 132 (e.g., in dependence on a type of the battery 132).

According to this configuration, as the remaining power threshold value L, the value added with (e.g., accounting for) the discharge characteristic of the battery 132 can be obtained.

Further, according to the information processing device 2 related to the present embodiment, the remaining power acquisition section 26a obtains the remaining battery power $W_R$ while printing the n-th label in the print job for printing a plurality of labels. As the predicted power consumption $W_C$, the arithmetic section 26c calculates the value consumed by the execution of the print job for performing printing on the (n+1)-th label and the following labels (up to the final, or N-th, label). The judgment section 26d judges whether or not the battery 132 has the remaining battery power $W_R$ with which the tape printer 1 can complete the print job for performing printing on the (n+1)-th label and the following labels based on the remaining battery power $W_R$ obtained while printing the n-th label and the predicted power consumption $W_C$.

According to this configuration, the remaining battery power $W_R$ is obtained in real time while performing printing on the plurality of labels. Therefore, according to the present configuration, whether or not the battery 132 has the remaining battery power $W_R$ with which the tape printer 1 can complete the print job can more appropriately be judged.

Further, according to the information processing device 2 related to the present embodiment, there is further provided a display 24 for displaying a message in the case in which it has been judged that the battery 132 fails to have the remaining battery power $W_R$ with which the tape printer 1 can complete the print job. The message may indicate that the battery 132 fails to have the remaining battery power $W_R$ to complete the print job.

According to the present configuration, it is possible to notify the user of the fact that the battery 132 fails to have the remaining battery power $W_R$ with which the tape printer 1 can complete the print job.

It should be noted that the print head 112 is an example of a "print section." The information processing device 2 is an example of a "judgment device."

It is obvious that the invention is not limited to the embodiment described above, but can adopt a variety of configurations within the scope and the spirit of the invention. For example, the present embodiment can be modified into the following configuration.

The arithmetic section 26c is not limited to the configuration of calculating the predicted power consumption $W_C$ based on the formula described above, but it is also possible to, for example, eliminate some of the terms of the formula described above, or add other terms in accordance with the characteristic of the tape printer 1.

The judgment section 26d is not limited to the configuration of making the judgment on whether or not the predicted remaining power $W_D$ is equal to or higher than the remaining power threshold value L, as the judgment on whether or not the battery 132 has the remaining battery power $W_R$ with which the tape printer 1 can complete the print job. It is also possible for the judgment section 26d to judge that the battery 132 has the remaining battery power $W_R$ with which the print job can be completed if the predicted power consumption $W_C$ is lower than 0.5 V in the case in which, for example, the remaining battery power $W_R$ is no lower than 6.0 V and lower than 6.5 V, and judge that the battery 132 has the remaining battery power $W_R$ with which the print job can be completed if the predicted power consumption $W_C$ is lower than 1.0 V in the case in which the remaining battery power $W_R$ is no lower than 6.5 V and lower than 7.0 V.

It is also possible for the information processing device 2 to be provided with, for example, a sound output device for giving a message with a sound instead of the display device such as the display 24 as an annunciation section.

It is also possible for the print-side control circuit 120 of the tape printer 1 to have a configuration functioning similarly to the processing-side control circuit 26 of the information processing device 2. In other words, it is also possible for the print-side control circuit 120 to have a configuration (see Fig. 11) functionally provided with a remaining power acquisition section 120a, a threshold value acquisition section 120b, an arithmetic section 120c, and a judgment section 120d. In this case, it is preferable for the tape printer 1 to be provided with the annunciation section for giving a message.

The invention is not limited to the tape printer 1, but can also be applied to a printer for performing printing on other printing media such as roll paper.

It is also possible for the invention to be provided as a program (e.g., the remaining battery power judgment processing program described above) for making the information processing device 2 function as the judgment device according to the invention, and a recording medium (e.g., a CD-ROM, a flash memory) storing the program.

**Claims**

1. A judgment device (2) comprising:

    a remaining power acquisition section (26a) adapted to obtain a remaining battery power of a battery (132) as a power source of a printer (1);
    an arithmetic section (26c) adapted to calculate a predicted power consumption of the battery (132) consumed by execution of a print job; and
    a judgment section (2 6d) adapted to judge whether or not the battery (132) has the remaining battery power, with which the printer (1) can complete the print job, based on the remaining battery power and the predicted power consumption.

2. The judgment device (2) according to Claim 1, wherein the arithmetic section (26c) is adapted to calculate the predicted power consumption based on a print density in the print job.

3. The judgment device (2) according to Claim 1, wherein the arithmetic section (26c) is adapted to calculate the predicted power consumption based on a number of times of a cutting process adapted to cut a print medium in the print job.

4. The judgment device (2) according to any one of Claims 1 to 3, further comprising:

    a threshold value acquisition section (26b) adapted to obtain a remaining power threshold value,
    wherein the judgment section (26d) is adapted to make, as the judgment on whether or not the battery (132) has the remaining battery power with which the printer (1) can complete the print job, a judgment on whether or not a predicted remaining power as a difference obtained by subtracting the predicted power consumption from the remaining battery power is one of equal to or higher than the remaining power threshold value.

5. The judgment device (2) according to Claim 4, wherein the threshold acquisition section is adapted to obtain the remaining power threshold value differently between types of the battery (132).

6. The judgment device (2) according to any one of Claims 1 to 5, wherein
    the remaining power acquisition section (26a) is adapted to obtain the remaining battery power while printing is performed on an n-th label out of the print job of performing printing on a plurality of labels, n being an integer no smaller than 1;
    the arithmetic section (26c) is adapted to calculate a value consumed by execution of the print job of performing printing on an (n+1)-th label and following labels as the predicted power consumption; and
    the judgment section (26d) is adapted to judge whether or not the battery (132) has the remaining battery power with which the printer (1) can complete the print job of performing printing on the (n+1)-th label and the following labels based on the remaining battery power obtained while performing printing on the n-th label, and the predicted power consumption.

7. The judgment device (2) according to any one of Claims 1 to 6, further comprising:

    an annunciation section adapted to generate a message in a case in which the judgment section (26d) judges that the battery (132) fails to have the remaining battery power with which the printer (1) can complete the print job.

8. A program making an information processing device function as the judgment device (2) according to any one of Claims 1 to 7.

9. A judgment method in a judgment device (2) comprising:

    obtaining a remaining battery power of a battery (132) as a power source of a printer (1);
    calculating a predicted power consumption of the battery (132) consumed by execution of a print job; and
    judging whether or not the battery (132) has the remaining battery power, with which the printer (1) can complete the print job, based on the remaining battery power and the predicted power consumption.

10. The judgement method according to Claim 9, further comprising:

calculating the predicted power consumption based on a print density in the print job; or
calculating the predicted power consumption based on a number of times of a cutting process adapted to cut a print medium in the print job.

11. The judgement method according to Claim 9 or 10, further comprising:

obtaining a remaining power threshold value,
wherein making the judgment on whether or not the battery (132) has the remaining battery power with which the printer (1) can complete the print job comprises making a judgment on whether or not a predicted remaining power as a difference obtained by subtracting the predicted power consumption from the remaining battery power is one of equal to or higher than the remaining power threshold value.

12. The judgement method according to any one of Claims 9 to 11, further comprising:

obtaining the remaining battery power while printing is performed on an n-th label out of the print job of performing printing on a plurality of labels, n being an integer no smaller than 1;
calculating a value consumed by execution of the print job of performing printing on an (n+1)-th label and following labels as the predicted power consumption; and
judging whether or not the battery (132) has the remaining battery power with which the printer (1) can complete the print job of performing printing on the (n+1)-th label and the following labels based on the remaining battery power obtained while performing printing on the n-th label, and the predicted power consumption.

13. A program making an information processing device perform the method steps of any one of Claims 9 to 12.

14. A printer (1) comprising:

a printing section (112) adapted to perform printing on a print medium; and
the judgment device according to any one of Claims 1 to 7.

15. A printer (1) comprising:

a printing section (112) adapted to perform printing on a print medium;
a remaining power acquisition section (120a) adapted to obtain a remaining battery power of a battery (132) as a power source;
an arithmetic section (120c) adapted to calculate a predicted power consumption of the battery (132) consumed by execution of a print job; and
a judgment section (120d) adapted to judge whether or not the battery (132) has the remaining battery power, with which the print job cab be completed, based on the remaining battery power and the predicted power consumption.

SY

101

C

T

Tb

Ta

102

1

24

21

2

22

23

# FIG. 1

D11                    D15

D12 — TAPE WIDTH        A B C |        D1

D13 —        mm

D14 — PRINT

## FIG. 2

D21 → FULL-CUT  ⦿ YES          HALF-CUT  ⦿ YES  ← D22
                ○ NO                      ○ NO

D23 → NUMBER OF
      PRINT SHEETS   [ 1 ] SHEETS

D24 → BATTERY TYPE  ⦿ ALKALINE BATTERY          D2
                    ○ NICKEL-METAL HYDRIDE BATTERY
                    ○ LITHIUM ION BATTERY

D25 → PRINT COLOR
      DENSITY      [ 0 ] (-3 – +3)

D26 → PRINT SPEED  [ 10 ] mm / sec (6 – 15)

## FIG. 3

SY

```
131   135         130              120           115                    1
 ○─┤ ├─┐  ┌──────────────┐ ┌──────────────┐ ┌──────────┐         ┌──────────────┐
          │ POWER SUPPLY │ │ PRINT-SIDE   │ │  FEED    │         │     FEED     │
          │              │ │ CONTROL      │ │  MOTOR   │─────────│  MECHANISM   │
          │      ┌────133│ │ CIRCUIT      │ └──────────┘         └──────────────┘
          │  ┌──────────┐│ │              │                          ┌───────112─┐
          │  │ POWER    ││ │  ┌─────121─┐ │                     ┌────┤ PRINT HEAD│
          │  │ SOURCE   ││ │  │  CPU    │ │                     │    │┌─────────┐│
          │  │ DETECTION││ │  └─────────┘ │                     │    ││  PRINT  ││
          │  │ SENSOR   ││ │  ┌─────122─┐ │                     │    ││TEMPERATURE│
          │  └──────────┘│ │  │  ROM    │ │─────────────────────┘    ││DETECTION││
 132      │      ┌────134│ │  └─────────┘ │                          ││ SENSOR  ││
  ╧       │  ┌──────────┐│ │  ┌─────123─┐ │         116              │└─────────┘│
          │  │ REMAINING││ │  │  RAM    │ │    ┌──────────┐          └──1121─────┘
          │  │ POWER    ││ │  └─────────┘ │    │  CUTTER  │          ┌───────113─┐
          │  │ DETECTION││ │              │────│  MOTOR   │──┬───────│ FULL-CUTTER│
          │  │ SENSOR   ││ │              │    └──────────┘  │       └───────────┘
          │  └──────────┘│ │              │                 │       ┌───────────┐
          └──────────────┘ └──────────────┘                 └───────│ HALF-CUTTER│
                                                                     └──────114──┘
                                            117
                                      ┌──────────────────┐
                                      │  TAPE WIDTH      │
                                      │ DETECTION SENSOR │
                                      └──────────────────┘
                                      ┌──────────────────┐
                                      │ ENVIRONMENTAL    │
                                      │ TEMPERATURE      │
                                      │ DETECTION SENSOR │
                                      └────────118───────┘
```

```
                    ┌──────────────────────────┐ 119
                    │   PRINT-SIDE INTERFACE    │
                    └──────────────────────────┘
                                 ┊
                    ┌──────────────────────────┐ 25
                    │ PROCESSING-SIDE INTERFACE │
                    └──────────────────────────┘
```

```
              ┌──────────────┐ 26                    2
              │ PROCESSING-  │
              │ SIDE         │
              │ CONTROL      │                    ┌──────────22─┐
              │ CIRCUIT      │           ┌────────│  KEYBOARD   │
     261─────│  ┌────────┐  │───────────┘        └─────────────┘
              │  │  CPU   │  │                    ┌──────────23─┐
     262─────│  │  ROM   │  │───────────┐        │    MOUSE    │
              │  ┌────────┐  │           └────────└─────────────┘
     263─────│  │  RAM   │  │                    ┌──────────24─┐
     264─────│  │  HDD   │  │───────────┐        │   DISPLAY   │
              │  └────────┘  │           └────────└─────────────┘
              └──────────────┘
```

# FIG. 4

271

| BATTERY TYPE | REMAINING POWER THRESHOLD VALUE L [V] |
|---|---|
| ALKALINE BATTERY | 5. 8 |
| NICKEL-METAL HYDRIDE BATTERY | 6. 3 |
| LITHIUM ION BATTERY | 6. 5 |

# FIG. 5

272

| | POWER CONSUMPTION [V] |
|---|---|
| PRINT POWER CONSUMPTION $W_P$ | 0. 0 0 1 |
| FULL-CUT POWER CONSUMPTION $W_F$ | 0. 0 0 8 |
| HALF-CUT POWER CONSUMPTION $W_H$ | 0. 0 1 5 |

# FIG. 6

273

| PRINT DENSITY [%] | PRINT DENSITY FACTOR a |
|---|---|
| NO LOWER THAN 50 | 1. 2 |
| NO LOWER THAN 20 AND LOWER THAN 50 | 1. 0 |
| LOWER THAN 20 | 0. 8 |

# FIG. 7

274

| PRINT COLOR DENSITY | PRINT COLOR DENSITY FACTOR b |
|---|---|
| + 3 | 1. 1 5 |
| + 2 | 1. 1 0 |
| + 1 | 1. 0 5 |
| 0 | 1. 0 0 |
| − 1 | 0. 9 5 |
| − 2 | 0. 9 0 |
| − 3 | 0. 8 5 |

# FIG. 8

275

| PRINT SPEED [mm / sec] | PRINT SPEED FACTOR c |
|:---:|:---:|
| 6 | 1 . 0 9 |
| 7 | 1 . 0 8 |
| 8 | 1 . 0 7 |
| 9 | 1 . 0 6 |
| 1 0 | 1 . 0 5 |
| 1 1 | 1 . 0 4 |
| 1 2 | 1 . 0 3 |
| 1 3 | 1 . 0 2 |
| 1 4 | 1 . 0 1 |
| 1 5 | 1 . 0 0 |

# FIG. 9

276

| ENVIRONMENTAL TEMPERATURE [°C] | ENVIRONMENTAL TEMPERATURE FACTOR d |
|---|---|
| LOWER THAN 10 | 1 . 2 |
| NO LOWER THAN 10 AND LOWER THAN 15 | 1 . 0 |
| NO LOWER THAN 15 | 0 . 8 |

# FIG.10

PROCESSING-SIDE
CONTROL CIRCUIT 26
( PRINT-SIDE
CONTROL CIRCUIT 120 )

| REMAINING POWER ACQUISITION SECTION |—26a (120a)

| THRESHOLD VALUE ACQUISITION SECTION |—26b (120b)

| ARITHMETIC SECTION |—26c (120c)

| JUDGMENT SECTION |—26d (120d)

# FIG.11

FIG.12

```
                              ┌───┐
                              │ A │
                              └─┬─┘
                                ↓
              ┌─────────────────────────────────┐
              │   PRINT JOB START INSTRUCTION    │ S14
              └─────────────────┬───────────────┘
                                ↓
              ┌─────────────────────────────────┐
              │            n = 1                 │ S15
              └─────────────────┬───────────────┘
                                ↓
              ┌─────────────────────────────────┐
              │    OBTAIN STATUS INFORMATION     │ S16
              └─────────────────┬───────────────┘
                                ↓
                              S17
                         ◇
              PRINT COMPLETION
         NOTIFICATION OF nth LABEL        No
           HAS BEEN RECEIVED ?         ──────→
                         ◇
                       Yes
                         ↓
                              S18
                  No     ◇
              ←──── POWER SOURCE
                     IS BATTERY ?
                         ◇
                       Yes
                         ↓
              ┌─────────────────────────────────┐
              │   REMAINING BATTERY POWER        │ S19
              │      JUDGMENT PROCESS            │
              └─────────────────┬───────────────┘
                                ↓
                              S20
              Yes        ◇
          ←────────    n = N ?
                         ◇
                       No
                         ↓
         ┌───┐   ┌─────────────────────────┐
         │ B │   │        n = n + 1         │ S21
         └───┘   └─────────────────────────┘
```

## FIG.13

START REMAINING
BATTERY POWER
JUDGMENT PROCESS

OBTAIN REMAINING POWER
THRESHOLD VALUE L | S31

CALCULATE PREDICTED
POWER CONSUMPTION $W_C$ | S32

S33

$W_D \geq L$ ?
($W_D = W_R - W_C$)

Yes

No

DISPLAY MESSAGE | S34

RETURN

# FIG.14

23

EP 3 185 119 A1

Europäisches
Patentamt

European
Patent Office

Office européen
des brevets

# EUROPEAN SEARCH REPORT

Application Number

EP 16 20 6697

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H10 105295 A (CANON KK) 24 April 1998 (1998-04-24) * paragraphs [0002] - [0016] * * paragraphs [0025], [0034] - [0037] * * paragraphs [0041] - [0052] * * figures 7-9 *<br>----- | 1-15 | INV.<br>G06F3/12<br>B41J3/36<br>B41J3/407<br>G06F1/26<br><br>ADD.<br>B41J29/393 |
| X | US 2002/033872 A1 (TAKAHASHI YASUO [JP]) 21 March 2002 (2002-03-21) * paragraphs [0016] - [0018] * * paragraphs [0031] - [0038] * * paragraphs [0053] - [0063] * * paragraphs [0083] - [0095] * * figures 1, 2A, 4, 6, 7 *<br>----- | 1-15 | |

TECHNICAL FIELDS
SEARCHED (IPC)

G06F
B41J
H04N
G06K

The present search report has been drawn up for all claims

| Place of search | Date of completion of the search | Examiner |
|---|---|---|
| The Hague | 9 May 2017 | Vilella, Josep |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 16 20 6697

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2017

| Patent document cited in search report | Publication date | Patent family member(s) | Publication date |
|---|---|---|---|
| JP H10105295 A | 24-04-1998 | NONE | |
| US 2002033872 A1 | 21-03-2002 | JP 2002137506 A<br>US 2002033872 A1 | 14-05-2002<br>21-03-2002 |

EPO FORM P0459

For more details about this annex : see Official Journal of the European Patent Office, No. 12/82

**REFERENCES CITED IN THE DESCRIPTION**

**Patent documents cited in the description**

- JP 2014188931 A